# EUROPEAN PATENT APPLICATION

(11) **EP 1 763 074 A2**
(43) Date of publication of application: **14.03.2007**
(21) Application number: 06120203.2
(22) Date of filing: 06.09.2006
(51) Int. Cl.: H01L 21/762, H01L 21/3065

(54) **Isolation for Semiconductor Devices**

(30) Priority: 09.09.2005 US 223232
(71) Applicant: Infineon Technologies AG, 81669 München (DE)
(72) Inventor: Tilke, Armin, Beacon, 12508 (US); Hong, Bee Kim, 01099, Dresden (DE)
(74) Representative: Kindermann, Peter

(57) **Abstract**

Methods of forming and structures for isolation structures for semiconductor devices are disclosed. The isolation structures are wider at the bottom than at the top, providing the ability to further scale the size of semiconductor devices. A first etch process is used to form a first trench portion, and a second etch process or an oxidation process is used to form a second trench portion beneath the first trench portion. The second trench portion is wider than the first trench portion. A liner may form during the first trench portion on the sidewalls of the first trench portion that protects the first trench portion sidewalls during the second etch process, in one embodiment. Alternatively, a liner may be deposited on the sidewalls of the first trench portion, in another embodiment.

## Description

### TECHNICAL FIELD

The present invention relates generally to the fabrication of semiconductor devices, and more particularly to the formation of isolation for semiconductor devices.

### BACKGROUND

Semiconductor devices are used in a variety of electronic applications, such as personal computers, cell phones, digital cameras, and other electronic equipment, as examples. Semiconductor devices are typically fabricated by sequentially depositing insulating (or dielectric) layers, conductive layers and semiconductive layers of material over a semiconductor substrate, and patterning the various layers using lithography to form circuit components and elements thereon.

A transistor is an element that is utilized extensively in semiconductor devices. There may be millions of transistors on a single integrated circuit (IC), for example. A common type of transistor used in semiconductor device fabrication is a metal oxide semiconductor field effect transistor (MOSFET).

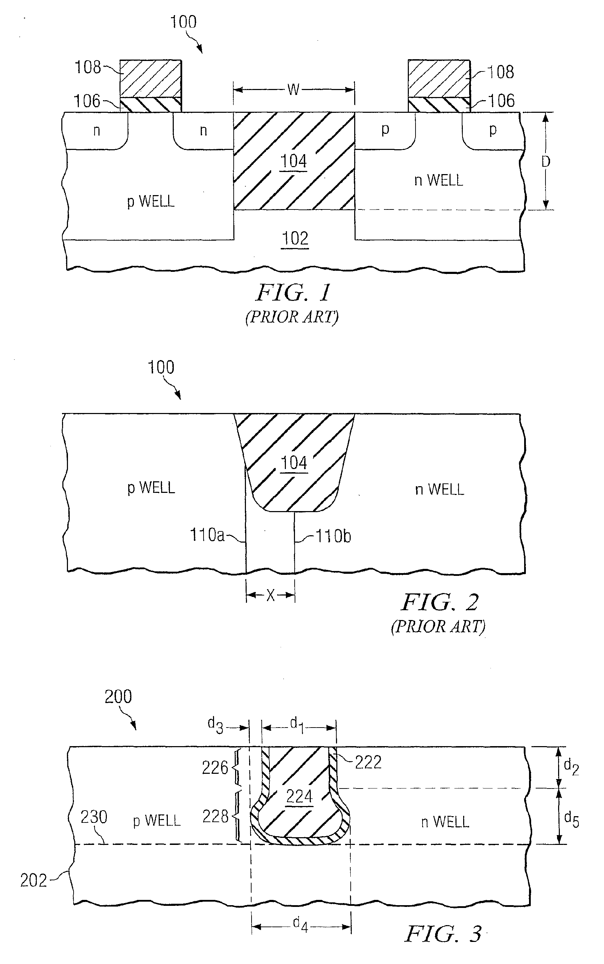

Early MOSFET processes used one type of doping to create either positive or negative channel transistors. More recent designs, referred to as complementary metal oxide semiconductor (CMOS) devices, use both positive and negative channel devices in complementary configurations, as shown in Figure 1 in a cross-sectional view. While manufacturing CMOS devices requires more manufacturing steps and more transistors, CMOS devices are advantageous because they utilize less power, and the devices may be made smaller and faster.

The positive and negative channel devices of CMOS devices are typically referred to as p channel metal oxide semiconductor (PMOS) and n channel metal oxide semiconductor (NMOS) transistors. The PMOS transistor is formed in an n well (e.g., a well implanted with n type dopants) and the NMOS transistor is formed in a p well. To manufacture CMOS transistors, typically, for example, a workpiece 102 or substrate is implanted with dopants to form the p well and n well. An isolation region often referred to in the art as a shallow trench isolation (STI) region 104 is formed between the n well and p well of the PMOS transistor and the NMOS transistor. The STI region 104 has a width W and a depth D within the workpiece 102. The STI region usually extends within the workpiece 102 by about the depth of the maximum n well and p well doping concentration, e.g., about 0.5 to 1.0 µm, for example.

A gate dielectric material 106 is deposited over the workpiece 102 and the STI region 104, and a gate material 108 is deposited over the gate dielectric material 106. The gate material 108 and the gate dielectric material 106 are patterned using lithography to form the gate and gate dielectric of the PMOS and NMOS transistors. Dopants are then implanted into the top surface of the p well and n well to form n type and p type source and drain regions of the transistors, for example. Sidewall spacers (not shown) may be formed over the sidewalls of the gates 108 and gate dielectric 106, and other processing steps may be continued (not shown) to complete the fabrication of the CMOS device 100, such as the deposition of insulating layers and the formation of contacts to make electrical contact to portions of the PMOS and NMOS transistors.

There are several problems with prior art methods of forming the STI regions 104 of CMOS transistors. The STI region 104 separates the p well from the n well. Because the p well and n well are implanted, they have a maximum dopant concentration at a certain depth within the workpiece 102. The trench for the STI region 104 should extend down to the maximum well dopant concentration. The breakdown voltage is reached when the depletion zone beginning in the source/drain (SD) regions from the one well (e.g., a p-SD for an n well and an n-SD for a p well) reaches the adjacent well. The depletion zone grows only slightly at a high dopant concentration, e.g., around the bottom of the STI region 104 trench. Therefore, the width of the STI bottom region is most important for the isolation performance of the STI region. The bottom of the STI region 104 trench should therefore be wide enough to assure that a sufficiently large voltage can be applied across both wells, without punch-through of the depletion zone. A similar situation exists for isolation between two SD regions in the same well, e.g., two n-SDs in one p well isolated by an STI region, or two p-SDs in one n well isolated by an STI region.

Another problem with prior art STI regions 104 is that the deeper the p well and n well are, the deeper the STI regions 104 need to be. Forming deeper trenches for the STI region 104 requires a thicker layer of photoresist for the mask for the implantation process, making it difficult to scale the CMOS device 100 or reduce the size.

Furthermore, misalignment due to unavoidable overlay tolerances in the lithographic process can result when the STI region 104 is formed, resulting in an STI region 104 that is not immediately disposed between or centered at the junction 1 10a of the p well and n well, as shown in Figure 2. For example, the STI region 104 trench may be centered around a point 110b (e.g., within the n well, in Figure 2) that is offset from the desired junction 110a of the p well and n well by an amount X. This misalignment causes device 100 failures, for example.

Thus, what are needed in the art are improved isolation structures for semiconductor devices and methods of fabrication thereof.

### SUMMARY OF THE INVENTION

These and other problems are generally solved or circumvented, and technical advantages are generally achieved, by preferred embodiments of the present invention, which provide novel methods of forming STI regions of semiconductor devices. STI regions are formed that have a retrograde shape, being wider at the bottom and narrower at the top.

In accordance with a preferred embodiment of the present invention, a method of forming an isolation structure for a semiconductor device includes providing a workpiece, and exposing the workpiece to a first etch process to form a first trench portion in the workpiece. The first etch process comprises a first bias power level, and the first trench portion has a first width. The workpiece is exposed to a second etch process to form a second trench portion beneath the first trench portion in the workpiece. The second etch process comprises a second bias power level, and the second trench portion has a second width. The second bias power level is greater than the first bias power level, and the second width is greater than the first width. The first trench portion and the second trench portion are filled with an insulating material.

In accordance with another preferred embodiment of the present invention, a method of forming an isolation structure for a semiconductor device includes providing a workpiece, and exposing the workpiece to a first etch process to form a first trench portion in the workpiece. The first trench portion has a first width. A protective liner is formed on the first trench portion, the protective liner comprising a thickness of less than 50 nm. The protective liner is removed from at least a bottom surface of the first trench portion. The workpiece is exposed to a second etch process to form a second trench portion beneath the first trench portion in the workpiece. The second trench portion has a second width, and the second width is greater than the first width. The first trench portion and the second trench portion are then filled with an insulating material.

In accordance with yet another preferred embodiment of the present invention, a method of forming an isolation structure for a semiconductor device includes providing a workpiece, and exposing the workpiece to a first process to form a first trench portion in the workpiece, the first trench portion having a first width, the first process comprising a first etch process. A protective liner is formed on the first trench portion, the protective liner comprising a nitride, a carbon-containing material, or a polymer. The protective liner is removed from at least a bottom surface of the first trench portion. The workpiece is exposed to a second process to form a second trench portion beneath the first trench portion in the workpiece. The second trench portion has a second width, the second width being greater than the first width. At least the first trench portion is then filled with an insulating material.

In accordance with another preferred embodiment of the present invention, a semiconductor device includes a workpiece, the workpiece having a top surface, and an isolation region formed within the workpiece. The isolation region includes a first portion proximate the top surface of the workpiece, the first portion having a first width and comprising sidewalls. The isolation region includes a second portion disposed beneath the first portion, the second portion having a second width, the second width being greater than the first width. The isolation region includes an insulating material disposed within the first trench portion and the second trench portion, wherein a liner does not reside along sidewalls of the first trench portion, between the insulating material and the workpiece.

Advantages of preferred embodiments of the present invention include providing novels methods of forming and structures for STI regions. The STI regions are wider at the bottom than at the top, yet because the optional protective liner on the sidewalls of the upper first portion is very thin, the trenches are easily filled with insulating material, resulting in a void-free fill. In one embodiment, voids may form in the lower part, but not the upper part of the trench in the fill process for the trenches. The novel STI regions may be scaled to a smaller size, allowing further reduction in the size of semiconductor devices.

The foregoing has outlined rather broadly the features and technical advantages of embodiments of the present invention in order that the detailed description of the invention that follows may be better understood. Additional features and advantages of embodiments of the invention will be described hereinafter, which form the subject of the claims of the invention. It should be appreciated by those skilled in the art that the conception and specific embodiments disclosed may be readily utilized as a basis for modifying or designing other structures or processes for carrying out the same purposes of the present invention. It should also be realized by those skilled in the art that such equivalent constructions do not depart from the spirit and scope of the invention as set forth in the appended claims.

### BRIEF DESCRIPTION OF THE DRAWINGS

For a more complete understanding of the present invention, and the advantages thereof, reference is now made to the following descriptions taken in conjunction with the accompanying drawings, in which:

Figure 1 shows a cross-sectional view of a prior art CMOS device having an STI region formed between a PMOS and an NMOS transistor;

Figure 2 illustrates the misalignment problems that can occur in prior art STI formation;

Figure 3 shows a novel STI region having a retrograde shape, in accordance with an embodiment of the present invention;

Figures 4 through 6 and 7A show cross-sectional views of a semiconductor device at various stages of manufacturing in accordance with a preferred embodiment of the present invention, wherein an STI region is formed using a two step etch process;

Figure 7B shows an optional liner that may be formed within the STI region trench, before filling the trench with insulating material, and voids that may form in the lower part of the trench;

Figures 8 through 10 show another preferred method of forming STI regions in accordance with an embodiment of the present invention, wherein a protective liner is formed in a top region of the trench;

Figures 11 through 13 show another preferred method of forming STI regions in accordance with an embodiment of the present invention, wherein a local oxidation process is used to widen the bottom of the trench while the upper part of the trench is protected by a nitride liner; and

Figures 14 through 17 show yet another preferred method of forming STI regions in accordance with an embodiment of the present invention, wherein, after forming the protecting nitride liner, an etch process is used to deepen the trench.

Corresponding numerals and symbols in the different figures generally refer to corresponding parts unless otherwise indicated. The figures are drawn to clearly illustrate the relevant aspects of the preferred embodiments and are not necessarily drawn to scale.

### DETAILED DESCRIPTION OF ILLUSTRATIVE EMBODIMENTS

The making and using of the presently preferred embodiments are discussed in detail below. It should be appreciated, however, that the present invention provides many applicable inventive concepts that can be embodied in a wide variety of specific contexts. The specific embodiments discussed are merely illustrative of specific ways to make and use the invention, and do not limit the scope of the invention.

The present invention will be described with respect to preferred embodiments in a specific context, namely, in the formation of STI regions for CMOS transistors. The invention may also be applied, however, to other isolation structures and methods of forming thereof for semiconductor devices.

In U.S. patent number 6,376,286, which is incorporated herein by reference, entitled, "Field Effect Transistor With Non-floating Body and Methods for Forming Same on a Bulk Silicon Wafer," issued on April 23, 2002 to Ju, a method of forming an STI region having a thinner portion at the top and a wider portion at the bottom is disclosed. A protective liner of silicon dioxide is formed at the top of the STI region, which protects the top portion of the trench during the etch process for the wider bottom portion of the trench. However, this protective liner is thick (500 to 1,000 Angstroms), and is particularly thicker towards the lower part of the trench, which can make filling the trench difficult in later processing steps.

Embodiments of the present invention include novel, improved methods of forming STI regions that are thinner at the top and wider at the bottom.

Referring next to Figure 3, a novel STI region 222/224 for a semiconductor device 200 in accordance with an embodiment of the present invention is shown in a cross-sectional view. An STI region 222/224 is formed in a semiconductor workpiece 202 having a top surface. The STI or isolation region 222/224 includes a first portion 226 proximate the top surface of the workpiece 202, the first portion 226 having a first width d₁ and comprising sidewalls. The first portion 226 extends into the workpiece 202 by a distance d₂. The isolation region 222/224 includes a second portion 228 disposed beneath the first portion 226, the second portion 228 having a second width d₄, the second width d₄ being greater than the first width d₁. The second portion 228 is preferably wider than the first portion 226 on each side by a distance d₃, as shown. The second portion 228 extends beneath the first portion 226 by a distance d₅. The STI region 222/224 extends to a point 230 within the workpiece 202, as shown, and may be formed between a p well and an n well of a CMOS device, as shown, as an example, although the STI region 222/224 may alternatively be formed in other devices or components of a semiconductor device 200, e.g., between one n-well or one p-well. The STI region 222/224 is filled with an insulating material 224 such as silicon dioxide.

The first width d₁ preferably comprises about 100 nm or less, and the second width d₄ preferably comprises about 150 nm or less, as examples, although alternatively, the first width d₁ and second width d₄ may comprise other dimensions, e.g., they may be larger. Advantageously, the first width d₁ and second width d₄ may be scaled to smaller dimensions, in accordance with embodiments of the present invention, due to the retrograde shape of the STI region 222/224. Alternatively, the first width d₁ and the second width d₂ may be greater than 200 nm, for example. The distance d₃ that the second portion 228 is preferably wider at each side than the first portion 226, is preferably about 20 nm or greater, for example. The distance d₂ may comprise about 200 nm or less, and the distance d₅ may comprise about 200 nm or less, for example. In some embodiments, the distance d₂ preferably comprises about half the total depth d₂ + d₅ of the trench for the STI region 222/224. Alternatively, d₁, d₂, d₃, d₄, and d₅ may comprise other dimensions, for example. As yet another example, the depth of the second portion 228, distance d₅ may be smaller than the depth of the first portion 226, distance d₂, in some embodiments.

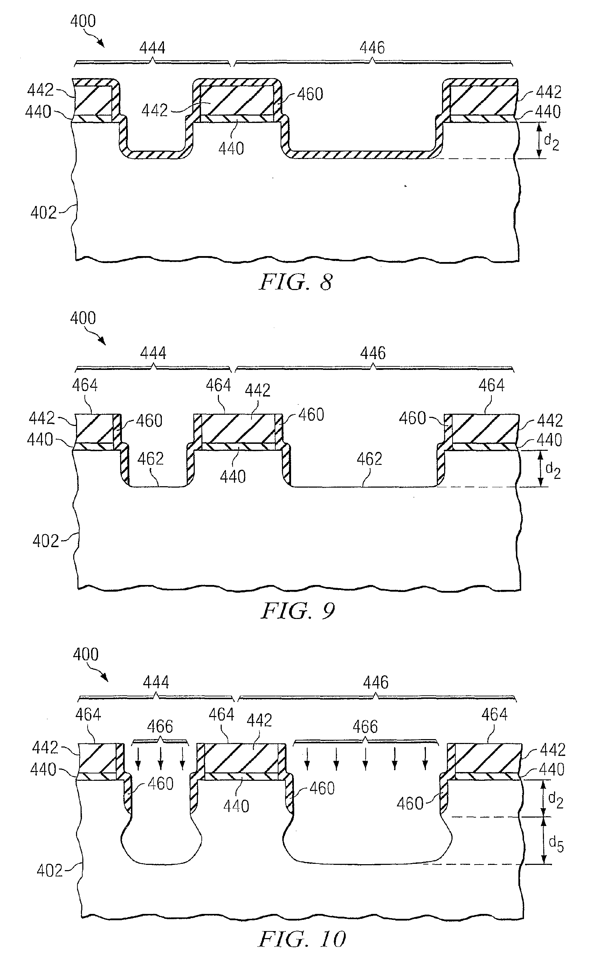

The STI region 222/224 may include an optional liner 222 formed on the sidewalls and bottom surface of a trench comprising the first portion 226 and the second portion 228 of the STI region. The STI region 222/224 may also include an optional liner formed on the sidewalls of the first portion 226 but not on the second portion 228 (not shown in Figure 3; see Figure 10 at 460). The optional liner 460 preferably comprises a thickness of less than about 50 nm, and more preferably comprises a thickness of less than about 25 nm. The optional liner 460 may comprise a polymer, SiO₂, SiₓN_{y}, SiC, or combinations or multiple layers thereof, to be described further herein.

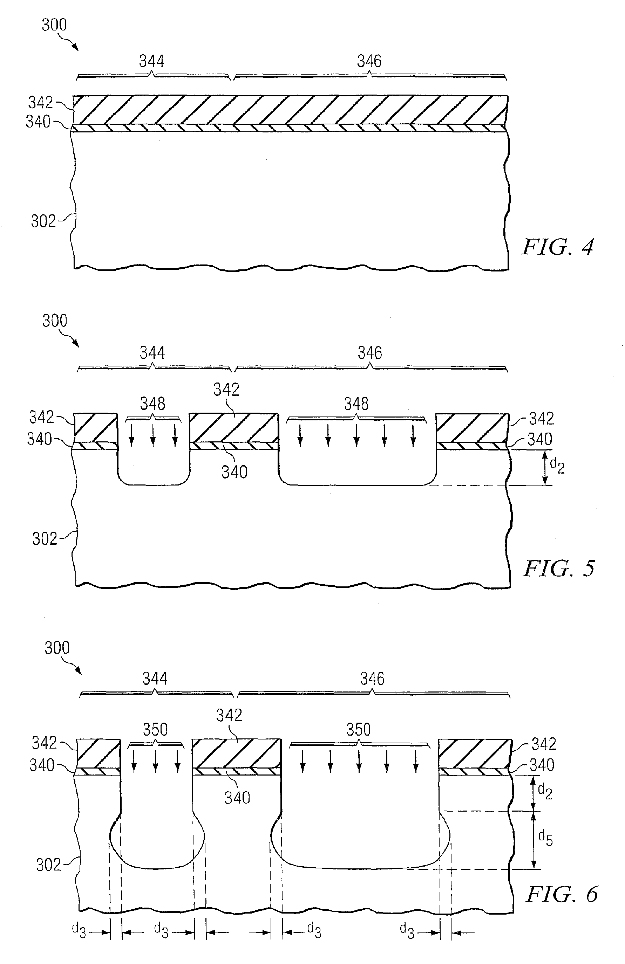

A method of manufacturing the novel STI region will next be described. Figures 4 through 6 and 7A show cross-sectional views of a semiconductor device 300 at various stages of manufacturing in accordance with a preferred embodiment of the present invention, wherein an STI region 352 or 354 is formed using a two step etch process. First, a workpiece 302 is provided. The workpiece 302 may include a semiconductor substrate comprising silicon or other semiconductor materials covered by an insulating layer, for example. The workpiece 302 may also include other active components or circuits, not shown. The workpiece 302 may comprise silicon oxide over single-crystal silicon, for example. The workpiece 302 may include other conductive layers or other semiconductor elements, e.g., transistors, diodes, etc. Compound semiconductors, GaAs, InP, Si/Ge, or SiC, as examples, may be used in place of silicon. The workpiece 302 may also comprise bulk Si, SiGe, Ge, SiC, or a silicon-on-insulator (SOI) substrate, as examples.

A pad oxide 340 is formed over the workpiece 302. The pad oxide 340 may comprise about 4 nm of silicon dioxide (SiO₂), for example, although the pad oxide 340 may alternatively comprise other materials and dimensions. A pad nitride 342 is formed over the pad oxide 340. The pad nitride 342 may comprise about 100 nm of silicon nitride (SiₓN_{y}), for example, although the pad nitride 342 may alternatively comprise other materials and dimensions.

The semiconductor device 300 may comprise a first region 344 and a second region 346, for example, wherein the first region 344 comprises a region where narrow STI regions will be formed, and wherein the second region 346 comprises a region where wider STI regions will be formed, for example. For example, STI regions in the first region 344 may comprise a width of about 80 nm or less, and STI regions in the second region 346 may comprise a width of about 500 nm or greater. Alternatively, STI regions comprising a single width, or more than one single width as well as continuous widths, may be formed across a surface of the semiconductor device 300, for example.

The workpiece 302 is exposed to a first etch process 348 to form a first trench portion in the workpiece, as shown in Figure 5. A photoresist and/or hard mask (not shown) may be deposited over the top surface of the pad nitride 342 and patterned with the desired pattern for the STI regions, for example, using lithography. The first etch process 348 preferably comprises a reactive ion etch (RIE) that is adapted to etch the workpiece 302, e.g., silicon. The first etch process 348 is preferably anisotropic, e.g., it is preferably etches directionally preferentially normal to the top surface of the workpiece 302. The first etch process 348 is continued for a predetermined period of time to etch the workpiece 302 by a predetermined amount or distance d₂. The first etch process 348 preferably comprises a first bias power level, and the first trench portion preferably comprises a first width.

Next, the workpiece 302 is exposed to a second etch process 350 (e.g., with the photoresist and/or hard mask, not shown, still left residing over the pad nitride 342), as shown in Figure 6, to form a second trench portion beneath the first trench portion in the workpiece 302. The second etch process 350 preferably an isotropic etch, e.g., it etches in a non-preferential direction. Preferably, in one embodiment, a bias power level is selected for the second etch process 350 that does not result in a substantial amount of etching of the sidewalls of the upper, first trench portion. The second etch process preferably comprises a second bias power level, wherein the second bias power level is greater than the first bias power level. The second trench portion has a second width, wherein the second width is greater than the first width of the first trench portion.

In one embodiment, the first etch process 348 results in the formation of a thin protective liner (not shown in Figure 6; see Figures 9 and 10) on the sidewalls of the upper, first trench portion, wherein the thin protective liner comprises a polymer. The thin protective liner may comprise a silicon polymer that is produced as a result of the first etch process 348, for example. The optional thin protective liner assists in preventing the sidewalls of the first trench portion from being etched during the second etch process 350, for example.

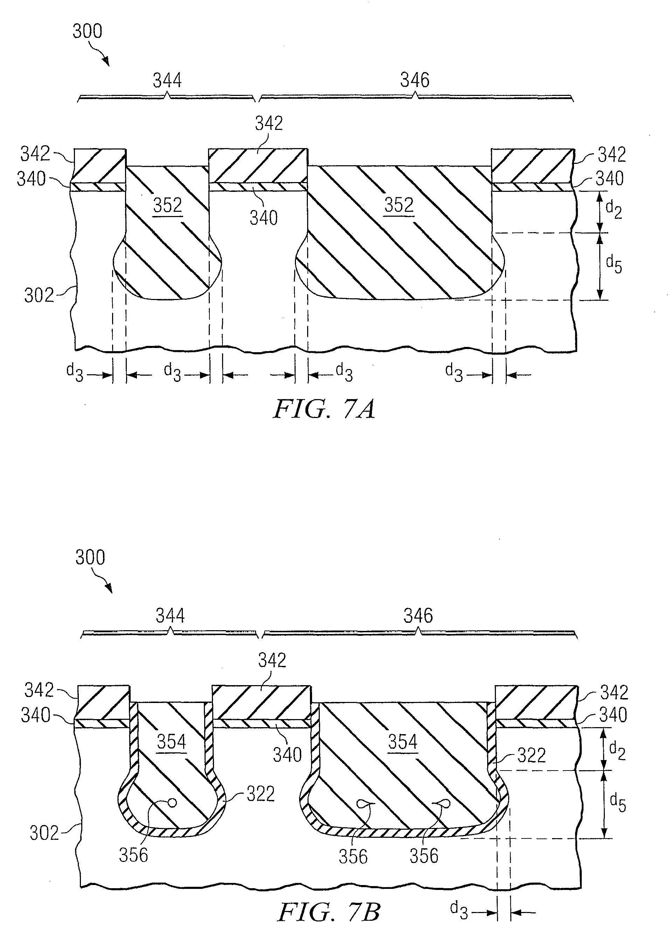

Next, the first trench portion and the second trench portion are filled with an insulating material 352, as shown in Figure 7A, or insulating material 354, as shown in Figure 7B. The fill process may comprise depositing a spin-on-glass (SOG) 352, as shown in Figure 7A, as one example. As another example, the fill process may comprise a conformal deposition of an insulator such as tetra ethyl oxysilane (TEOS), using a high aspect ratio fill process (such as HARP^{™} by Applied Materials, Inc.) 354, as shown in Figure 7B. However, alternatively, other processes and insulating materials may be used to fill the first trench portion and the second trench portion.

The insulating material 352 preferably comprises a dielectric material typically used for STI in semiconductor devices, for example, such as silicon dioxide. If a conformal fill like HARP^{™} is used to fill the STI regions, voids 356 may form in the second trench portions, as shown in Figure 7B. Advantageously, the voids 356 form in the lower part of the STI trench, where the voids do not affect the isolation properties, e.g., by forming shorts.

Because the optional thin protective liner that is formed on the sidewalls of the first trench portions is very thin, e.g., about 20 nm or less, advantageously, the protective liner does not impede the filling of the trenches with the insulating material 352 or 354, in accordance with preferred embodiments of the present invention. In particular, in one embodiment, a protective liner comprising a polymer that may be formed during the etch process may be removed in subsequent cleaning steps, for example. Furthermore, protective liners comprising silicon oxide or nitride materials may be removed prior to the trench fill process, so that the protective liners will not affect the fill process at all, for example.

In the embodiments shown in Figures 4 through 6, 7A, and 7B, the first etch process 348 may comprise a first source power level, and the second etch process 350 may comprise a second source power level, wherein the second source power level is greater than the first source power level, for example. The first source power level of the first etch process 348 may comprise in the range of about 100 to 300 watts, e.g., about 300 watts or less, using a dual plasma source (DPS) plasma etch process, and the second source power level of the second etch process 350 may be in the range of about 500 to 800 watts, e.g., about 500 watts or greater, using a DPS etch process, as examples, although alternatively, other source power levels may be used for the first and second etch processes 348 and 350. In one embodiment, the first etch process 348 preferably comprises a first pressure, and the second etch process 350 comprises a second pressure, wherein the second pressure is greater than the first pressure. For example, the first pressure may comprise in the range of about 5 to 20 milliTorr (mT), e.g., about 20 mT or less, and the second pressure may comprise in the range of about 50 to 80 mT, e.g., about 50 mT or greater, although alternatively, other pressure levels may be used. In another embodiment, the first etch process 348 comprises a first bias power level, and the second etch process 350 comprises a second bias power level, wherein the second bias power level is greater than the first bias power level. For example, the first bias power level may comprise a low bias power (BP) of about 50 watts or less, and the second bias power level may comprise a higher BP of about 200 watts or greater, although alternatively, other bias power levels may be used for the first and second etch processes 348 and 350.

Figure 7B also shows an optional liner 322 that may be formed within the STI region trench, before filling the trench with insulating material. For example, the liner may comprise about 5 to 10 nm of SiO₂, although alternatively, other materials may be used. The optional liner 322 may be used to repair the sidewalls of the workpiece 302 after the first and second etch processes, for example.

Figures 8 through 10 show another preferred method of forming STI regions in accordance with an embodiment of the present invention, wherein a protective liner 460 is formed in a top region of the trench. Like numerals are used in Figures 8 through 10 as were used in the previous figures.

In this embodiment, after the first etch process 348 shown in Figure 5, a thin protective liner 460 is deposited on the workpiece 402. The thin protective liner 460 protects the sidewalls of the first trench portion during the second etch process 466, as shown in Figure 10.

The liner 460 preferably comprises SiO₂, SiₓN_{y}, SiC, or combinations or multiple layers thereof. More preferably, in some embodiments, the liner 460 comprises SiₓN_{y} or SiC, which are materials that provide good protection for a silicon substrate such as workpiece 402 during the second etch process. The liner 460 is preferably conformal, and is deposited evenly over the top surface of the pad nitride 442, sidewalls of the pad nitride 442, pad oxide 440, and workpiece 402, and over the bottom surface of the first trench portion, as shown in Figure 8. The liner 460 may be formed by chemical vapor deposition (CVD), for example.

Advantageously, the liner 460 is preferably thin enough that its presence on the sidewalls of the workpiece 402 in the first trench portion will not impede the later manufacturing step of filling the trench. For example, the liner 460 is preferably less than 50 nm in thickness. More preferably, the liner 460 comprises a thickness of about 25 nm or less, and most preferably, the liner 460 comprises a thickness of 10 nm or less, as examples, although alternatively, the liner 460 may comprise other dimensions.

The liner 460 is anisotropically etched to remove the liner 460 from the bottom surface 462 of the first trench portion, leaving the structure shown in Figure 9. Note that the liner 460 may also be removed from the top surface 464 of the pad nitride 442 (not shown). Next, the second etch process 466 is used to form the second trench portion that is wider than the first trench portion beneath the first trench portion, as shown in Figure 10. The trenches are then filled, as described with reference to Figures 7A and 7B.

In one embodiment, as mentioned previously herein, the liner 460 is not deposited in a separate deposition step, but rather, the liner 460 forms during the first etch process 348, as shown in Figure 9. This occurs as by-products of the first etch process 348 form and deposit on the sidewalls of the first trench portion. In this embodiment, the liner 460 comprises a polymer comprised of the silicon from the workpiece 402, materials used in the first etch process 348, and possibly also debris, solvents, and/or particulates residing on the workpiece 402 or in the chamber the etch process 348 takes place in, as examples. This embodiment is advantageous because an additional step is not needed to form the thin protective liner 460; rather, the liner 460 naturally forms, as a result of the first etch process 348. In this embodiment, a first etch process 348 may be selected and tuned to achieve the formation of the liner 460, for example.

However, in some embodiments, the liner 460 is not formed, either intentionally or as a result of the first etch process 348. In these embodiments, the first etch process parameters are selected and tuned to minimize removal or etching of the sidewalls of the first trench portion during the second etch process 350 (see Figure 6), for example.

An example of an experimental result of manufacturing an embodiment of the present invention will next be described. On a workpiece such as workpiece 302 shown in Figure 4 having a pad oxide 340 and pad nitride 342 formed thereon, a break-through etch process was used to open or pattern the pad oxide 340 and pad nitride 342. The break-through etch process was performed at less than about 12 mT, using a source power of about 300 or less, at about 150 watts BP or less, and using CF₄, for about 10 seconds or less. The first etch process 348 (see Figure 5) comprised a pressure of about 20 mT or less, with about 300 watts or less source power, at about 50 watts or less BP, using HeO₂ and HBR. The second etch process 350 (see Figure 6) comprised a pressure of about 50 mT or greater, with about 500 watts or greater source power, at about 200 watts BP or less, using HeO₂ and CF₄. No additional deposition steps were required to form a liner; the upper first trench portions were protected by a polymer that formed during the first etch process 348. An STI trench structure having rounded bottom portions was achieved, having top portions with a width of about 160 to 190 nm, and having bottom portions with a width of about 175 to 200 nm, as examples.

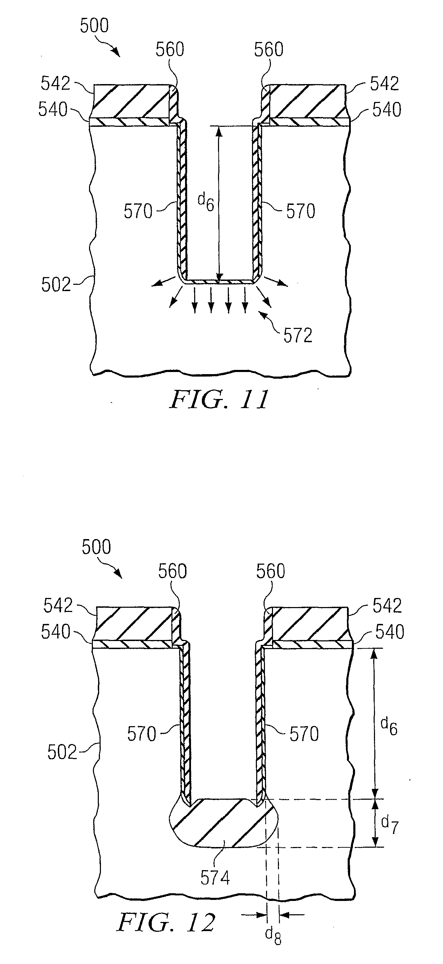

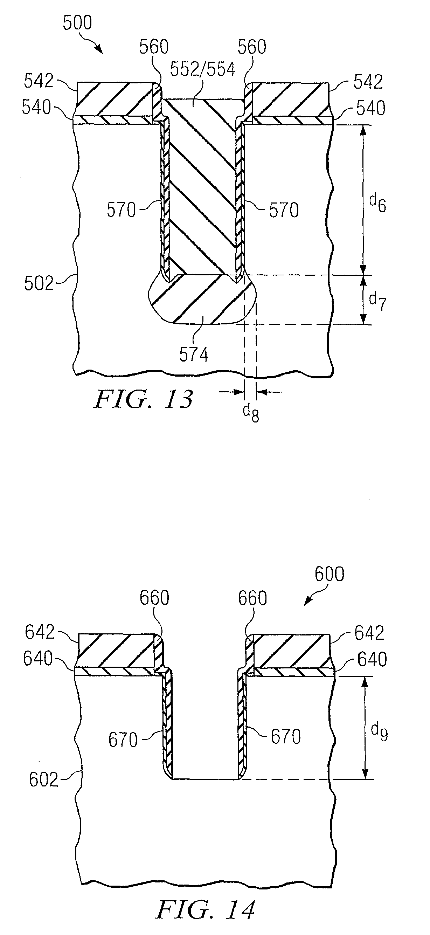

Figures 11 through 13 show another preferred method of forming STI regions in accordance with an embodiment of the present invention, wherein a local oxidation process is used to widen the bottom of the trench for the STI region while the upper part of the trench is protected by a nitride liner. Again, like numerals are used in Figures 11 through 13 as were used in the previous figures. Referring next to Figure 11, a first etch process such as etch process 348 in Figure 5 is used to form a first portion of the STI trench. In this embodiment, the first portion of the trench formed by the first etch process 348 preferably forms a trench first portion that comprises a distance d₆ that is equivalent of almost the entire desired depth of the trench for the STI region. For example, the first portion of the trench formed by the first etch process 348 may comprise a distance d₆ that is about ¾ or greater, and more preferably about 7/8 or greater, of the entire trench depth (e.g., (distance d₆ + distance d₇) shown in Figures 12 and 13). The distance d₆ may comprise about 300 nm or greater, as an example, although other dimensions may be used.

A thin oxide liner 570 is formed on the sidewalls and bottom surface of the first portion of the trench, as shown in Figure 11. The thin oxide liner 570 may be formed by furnace oxidation or rapid thermal oxidation (RTO), as examples, although other methods may alternatively be used. The thin oxide liner 570 preferably comprises a thickness of about 5 nm or less, for example, although the thin oxide liner 570 may alternatively comprise other dimensions.

A thin protective liner 560 is formed over the thin oxide liner 570. The thin protective liner 560 preferably comprises the same materials and dimensions as described for thin protective liner 460 in Figures 8 through 10, for example, and in one embodiment preferably comprises a nitride. The thin protective liner 560 is anisotropically etched to remove the liner 560 from the bottom surface of the first trench portion, leaving the structure shown in Figure 11 with the thin oxide liner 570 at the bottom of the first trench portion exposed. The liner 560 may also be removed from the top surface of the pad nitride 542, as shown.

Next, the workpiece 502 is exposed to an oxidation process 572, as shown in Figure 11, to cause the thin oxide liner 570 to thicken in the bottom portion of the trench, as shown in Figure 12. The workpiece 502 may be exposed to a LOCal Oxidation of Silicon (LOCOS) process to cause oxide growth at the bottom of the first portion of the trench, forming a second portion of the trench beneath the first portion of the trench that is filled with an oxide (e.g., such as SiO₂.) For example, the workpiece 502 may be exposed to a furnace oxidation, e.g., in a furnace in the presence of an oxygen-containing gas, at a temperature of about 900 degrees C for a time period of about 60 minutes, as examples, although other ambient parameters may alternatively be used. The distance d₇ comprising the thickness of the second portion of the trench that is filled with the oxide preferably comprises about 30 nm or greater, as an example, although distance d₇ may alternatively comprise other dimensions. Advantageously, the LOCOS process also causes oxidation in the lateral direction, e.g., by a distance d₈, which may comprise about 30 mn or greater, for example.

The remainder of the trench, e.g., the upper first portion of the trench, is filled with an insulating fill material 552 or 554, as described with reference to Figures 7A and 7B. Advantageously, the thin protective liner 560 preferably comprises a material such as a nitride that will not oxidize during the LOCOS process, for example, preventing the upper, first portion of the trench from filling with oxide material, and providing a better, more even, void-free fill for the STI region.

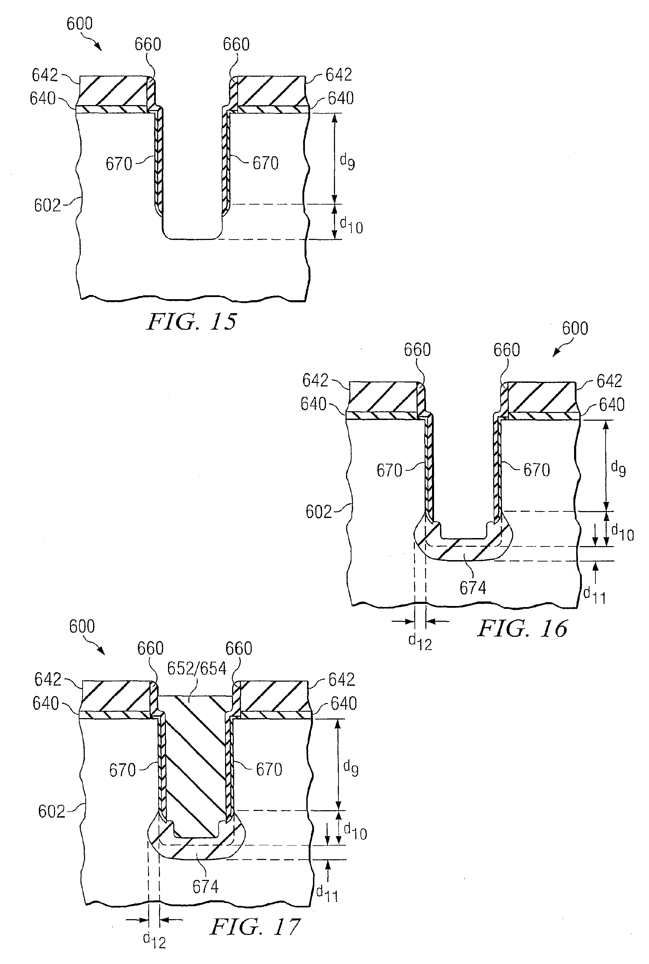

Figures 14 through 17 show yet another preferred method of forming STI regions in accordance with an embodiment of the present invention. Like numerals are used in Figures 14 through 17 as were used in the previous figures. In this embodiment, after forming the thin oxide liner 670 and sidewall-protecting nitride liner 660 within the first portion of the trench as described with reference to Figure 11, an etch process such as a RIE is used to deepen the trench by a distance d₁₀, as shown in Figure 15, prior to oxidizing the lower part of the trench, as shown in Figure 16.

In this embodiment, preferably the upper first portion of the trench for the STI region comprises a distance d₉ beneath the top surface of the workpiece 602, wherein the distance d₉ preferably comprises about 2/3 or greater of the full trench depth (e.g., the total of distances (d₉ + d₁₀ + d₁₁) in Figures 16 and 17). The etch process removes the oxide liner 670 in the bottom of the first portion of the trench and deepens the trench by a distance d₁₀, as shown in Figure 15. An oxidation process such as the one described with reference to Figure 12 is then used to oxidize the unprotected bottom portion of the trench, e.g., the bottom portion of the trench not protected by liner 670.

The oxidation process causes the portion of the trench beneath the first portion protected by the liner 670 to both fill with oxide 674 and form the oxide 674 laterally by a distance d₁₂ and vertically in a downward direction within the workpiece 602 by a distance d₁₁, as shown in Figure 16. The distance d₉ is preferably about 300 nm or less, distance d₁₀ is preferably about 50 nm or greater, and distances d₁₁ and d₁₂ are preferably about 30 nm or greater, as examples, although alternatively distances d₉, d₁₀, d₁₁, and d₁₂ may comprise other dimensions. Deepening the trench before the oxidation process makes the lateral oxidation process more effective, for example.

After the oxidation process, the upper portion of the trench is filled with an insulating material 652/654, as described as described with reference to Figures 7A and 7B.

In the embodiments shown in Figures 11 through 13 and Figures 14 through 17, the oxidation process for the lower, second portion of the trench substantially fills the lower, second portion, thus making it easier to fill the upper, first portion of the trench without void formation, for example.

Advantages of embodiments of the invention include providing novel methods of forming STI regions 222/224 (Figure 3), 352 (Figure 7A), 354 (Figure 7B), 552/554/574 (Figure 13), and 652/654/674 (Figure 17) of semiconductor devices 200, 300, 400, 500, and 600. The STI regions 222/224, 352, 354, 552/554/574, and 652/654/674 are wider at the bottom than the top, yet because the optional protective liner 460, 560, and 660 on the sidewalls of the upper first portion is very thin, the trenches for the STI regions are easily filled with insulating material, resulting in a void-free fill. In one embodiment, voids may form in the lower part, but not the upper part of the trench. In other embodiments, the protective liner 460, 560, and 660 is removed before filling the STI regions, further making the STI region trenches easier to fill, for example.

The shape of the STI regions 222/224, 352, 354, 552/554/574, and 652/654/674 allows a further reduction in semiconductor device size. Active regions proximate the upper surface of the workpiece 202, 302, 402, 502, and 602 may be placed closer together, while in the lower regions, the wider regions of insulating material in the lower second portion of the trench provide improved isolation.

Although embodiments of the present invention and their advantages have been described in detail, it should be understood that various changes, substitutions and alterations can be made herein without departing from the spirit and scope of the invention as defined by the appended claims. For example, it will be readily understood by those skilled in the art that many of the features, functions, processes, and materials described herein may be varied while remaining within the scope of the present invention. Moreover, the scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed, that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

## Claims

1. A method of forming an isolation structure for a semiconductor device, the method comprising:
providing a workpiece;
exposing the workpiece to a first etch process to form a first trench portion in the workpiece, the first etch process comprising a first bias power level, the first trench portion having a first width;
exposing the workpiece to a second etch process to form a second trench portion beneath the first trench portion in the workpiece, the second etch process comprising a second bias power level, the second trench portion having a second width, wherein the second bias power level is greater than the first bias power level, and wherein the second width is greater than the first width; and
filling the first trench portion and the second trench portion with an insulating material.

2. The method according to Claim 1, wherein the first bias power level of the first etch process comprises a bias power (BP) of about 50 watts or less, and wherein the second bias power level of the second etch process comprises a BP of about 200 watts or greater.

3. The method according to Claim 1, wherein the first width comprises about 100 nm or less, and wherein the second width comprises about 150 nm or less.

4. The method according to Claim 1, wherein the first etch process comprises a first pressure, wherein the second etch process comprises a second pressure, wherein the second pressure is greater than the first pressure.

5. The method according to Claim 4, wherein the first pressure comprises about 20 milliTorr (mT) or less, and wherein the second pressure comprises about 50 mT or greater.

6. The method according to Claim 1, wherein the first etch process comprises a first source power level, wherein the second etch process comprises a second source power level, wherein the second source power level is greater than the first source power level.

7. The method according to Claim 6, wherein the first source power level of the first etch process comprises about 300 watts or less using a dual plasma source (DPS) etch process, and wherein the second source power level of the second etch process comprises about 500 watts or greater using a DPS etch process.

8. The method according to Claim 1, wherein filling the first trench portion and the second trench portion with an insulating material comprises filling the first trench portion and the second trench portion with an insulating material with silicon dioxide.

9. The method according to Claim 8, wherein filling the first trench portion and the second trench portion with an insulating material further comprises forming a liner over the first trench portion and the second trench portion, before filling the first trench portion and the second trench portion with the silicon dioxide.

10. The method according to Claim 1, wherein filling the first trench portion and the second trench portion with an insulating material comprises forming voids in the second trench portion, but not the first trench portion.

11. The method according to Claim 1, wherein filling the first trench portion and the second trench portion with an insulating material comprises filling the first trench portion and the second trench portion with spin-on-glass (SOG) or tetra ethyl oxysilane (TEOS).

12. The method according to Claim 1, wherein exposing the workpiece to a first etch process comprises forming a polymer on the sidewalls of the first trench portion, wherein the polymer protects the sidewalls of the first trench portion while exposing the workpiece to the second etch process.

13. A semiconductor device manufactured in accordance with Claim 1.

14. A method of forming an isolation structure for a semiconductor device, the method comprising:
providing a workpiece;
exposing the workpiece to a first etch process to form a first trench portion in the workpiece, the first trench portion having a first width;
forming a protective liner on the first trench portion, the protective liner comprising a thickness of less than 50 nm;
removing the protective liner from at least a bottom surface of the first trench portion; exposing the workpiece to a second etch process to form a second trench portion beneath the first trench portion in the workpiece, the second trench portion having a second width, wherein the second width is greater than the first width; and
filling the first trench portion and the second trench portion with an insulating material.

15. The method according to Claim 14, wherein forming the protective liner comprises forming a polymer, an oxide, a nitride, or a carbon-containing material.

16. The method according to Claim 15, wherein forming the protective liner comprises forming SiO₂, SiₓN_{y}, SiC, or combinations or multiple layers thereof.

17. The method according to Claim 14, wherein forming the protective liner comprises forming a liner comprising a thickness of about 25 nm or less.

18. The method according to Claim 14, wherein forming the protective liner comprises forming the protective liner on sidewalls of the first trench portion, further comprising removing the protective liner from the sidewalls of the first trench portion, before filling the first trench portion and the second trench portion with the insulating material.

19. A method of forming an isolation structure for a semiconductor device, the method comprising:
providing a workpiece;
exposing the workpiece to a first process to form a first trench portion in the workpiece, the first trench portion having a first width, the first process comprising a first etch process;
forming a protective liner on the first trench portion, the protective liner comprising a nitride, a carbon-containing material, or a polymer;
removing the protective liner from at least a bottom surface of the first trench portion;
exposing the workpiece to a second process to form a second trench portion beneath the first trench portion in the workpiece, the second trench portion having a second width, wherein the second width is greater than the first width; and
filling at least the first trench portion with an insulating material.

20. The method according to Claim 19, wherein forming the protective liner comprises forming a liner comprising a thickness of less than about 50 nm.

21. The method according to Claim 19, wherein forming the protective liner comprises forming SiₓN_{y}, SiC, or combinations or multiple layers thereof, or combinations or multiple layers thereof with SiO₂.

22. The method according to Claim 19, wherein exposing the workpiece to the second process comprises exposing the workpiece to a second etch process, and wherein filling at least the first trench portion with the insulating material further comprises filling the second trench portion with the insulating material.

23. The method according to Claim 19, wherein exposing the workpiece to the second process comprises oxidizing the bottom surface of the first trench portion, wherein the second trench portion comprises an oxidized portion of the workpiece beneath the first trench portion.

24. The method according to Claim 23, wherein oxidizing the bottom surface of the first trench portion comprises a LOCal Oxidation of Silicon (LOCOS) process.

25. The method according to Claim 23, further comprising exposing the workpiece to a second etch process, before oxidizing the bottom surface of the first trench portion.

26. The method according to Claim 23, further comprising forming an oxide liner over the first trench portion, before forming the protective liner.

27. A semiconductor device, comprising:
a workpiece, the workpiece having a top surface; and
an isolation region formed within the workpiece, the isolation region comprising a first portion proximate the top surface of the workpiece, the first portion having a first width and comprising sidewalls, the isolation region comprising a second portion disposed beneath the first portion, the second portion having a second width, the second width being greater than the first width, the isolation region including an insulating material disposed within the first trench portion and the second trench portion, wherein a liner does not reside along the sidewalls of the first trench portion, between the insulating material and the workpiece.

28. The semiconductor device according to Claim 27, further comprising a first liner disposed on the sidewalls of the first portion, the first liner comprising a thickness of less than 50 nm.

29. The semiconductor device according to Claim 28, wherein the first liner comprises a polymer, SiO₂, SiₓN_{y}, SiC, or combinations or multiple layers thereof.

30. The semiconductor device according to Claim 28, further comprising a second liner disposed over the first liner within the first trench portion and over sidewalls and a bottom surface of the second trench portion.

31. The semiconductor device according to Claim 28, wherein the first liner comprises a polymer, SiₓN_{y}, SiC, or combinations or multiple layers thereof, further comprising a second liner disposed between the first liner and the sidewalls of the first portion of the isolation region, wherein the second liner comprises an oxide.

32. The semiconductor device according to Claim 27, further comprising a first transistor disposed proximate a first side of the isolation region and a second transistor disposed proximate a second side of the isolation region, wherein the semiconductor device comprises a complementary metal oxide semiconductor (CMOS) device.
